# EUROPÄISCHE PATENTANMELDUNG

(11) **EP 1 098 329 A2**
(43) Veröffentlichungstag der Anmeldung: **09.05.2001**
(21) Anmeldenummer: 00115254.5
(22) Anmeldetag: 14.07.2000
(51) Int. Cl.: H01H 5/04, H03K 17/968, H03K 17/97

(54) **Schaltmodul zum Schalten von Steuerstrombahnen, insbesondere in Fahrzeugen**

(30) Priorität: 05.11.1999 DE 19953204
(71) Anmelder: Valeo Schalter und Sensoren GmbH, 74321 Bietigheim-Bissingen (DE)
(72) Erfinder: Bauer, Jürgen, 71732 Tamm (DE); Neckel, Klaus, 74343 Sachsenheim-Spielberg (DE); Neubauer, Walter, 74348 Lauffen a.N. (DE)
(74) Vertreter: Steimle, Josef, Dipl.-Ing.

(57) **Zusammenfassung**

Die Erfindung geht aus von einem Schaltmodul zum Schalten von Steuerstrombahnen, insbesondere in Fahrzeugen, mit einem Schaltmodulgehäuse, mit einer insbesondere von einer menschlichen Person betätigbaren Betätigungseinheit und mit einem mit der Betätigungseinheit in Verbindungswirkung stehendenx, die Steuerstrombahn schaltenden Schaltglied.

Die Erfindung zeichnet sich dadurch aus, dass die Betätigungseinheit einen in dem Schaltmodulgehäuse angeordneten Schaltarm von einer definierten Schaltstellung, ohne ein Verbleiben des Schaltarms in einer Zwischenstellung, in eine andere definierte Schaltstellung betätigt, dass an dem Schaltarm das Schaltglied angeordnet ist und dass das Schaltglied die Steuerstrombahn berührungslos schaltet.

## Beschreibung

Die Erfindung betrifft ein Schaltmodul zum Schalten von Steuerstrombahnen, insbesondere in Fahrzeugen, mit einem Schaltmodulgehäuse, mit einer insbesondere von einer menschlichen Person betätigbaren Betätigungseinheit und mit einem mit der Betätigungseinheit in Verbindungswirkung stehenden, die Steuerstrombahn schaltenden Schaltglied.

Derartige Schaltmodule sind aus dem Stand der Technik in vielfältiger Art und Weise bekannt geworden. Die Schaltglieder solcher Schaltmodule schließen bzw. öffnen in der entsprechenden Schaltstellung die Steuerstrombahn mechanisch. Eine derartige Schalttechnik ist hinreichend bekannt und ausgereift. Jedoch kommt es aufgrund von Schaltfunken bzw. Lichtbögen zum mechanischen Verschleiß und zu einer Aufwärmung des Schaltgliedes. Außerdem müssen die einzelnen Bauteile des Schaltmoduls mit sehr kleinen Toleranzen hergestellt und hochexakt montiert werden, so dass die gewünschten Schaltpunkte realisierbar sind.

Der Erfindung liegt daher die Aufgabe zugrunde, ein Schaltmodul bereitzustellen, bei dem der Verschleiß wesentlich geringer ist und welches beim Schalten keine Temperaturänderungen erfährt. Außerdem sollte das Schaltmodul ein gerlingeres Toleranzproblem aufweisen.

Diese Aufgabe wird bei einem Schaltmodul der eingangs beschriebenen Art erfindungsgemäß dadurch gelöst, dass die Betätigungseinheit einen in dem Schaltmodulgehäuse angeordneten Schaltarm von einer definierten Schaltstellung, ohne ein Verbleiben des Schaltarms in einer Zwischenstellung, in eine andere definierte Schaltstellung betätigt, dass an dem Schaltarm das Schaltglied angeordnet ist und dass das Schaltglied die Steuerstrombahn berührungslos schaltet.

Der erfindungsgemäße Gegenstand hat den wesentlichen Vorteil, dass das Schaltglied berührungslos arbeitet, so dass kein mechanischer Verschleiß zu befürchten ist. Um einen exakten Schaltpunkt des Schaltmoduls zu gewährleisten, betätigt die Betätigungseinheit den Schaltarm von einer Schaltstellung in die andere, ohne dass ein Verbleiben des Schaltarms in einer Zwischenstellung möglich ist. Aufgrund der Anordnung des Schaltglieds an dem Schaltarm kann das Schaltglied die Steuerstrombahn zu exakt vorgegebenen Schaltpunkten schalten. Ein solches erfindungsgemäßes Schaltmodul weist dabei ein Schmitt-Trigger-Verhalten auf, welches sich dadurch kennzeichnet, dass unabhängig vom Zustand der betätigbaren Betätigungseinheit, welche auch Zwischenstellungen annehmen kann, das Schaltglied nur die definierten Schaltzustände AEIN@ und AAUS@ annehmen kann.

Derartige Schaltmodule haben zudem den wesentlichen Vorteil, dass mit ihnen sowohl große als auch sehr kleine Ströme geschaltet werden können, ohne dass hierfür besondere Maßnahmen getroffen werden müssen. Das Einsatzgebiet derartiger Schaltmodule liegt bevorzugt im Bereich des Kraftfahrzeugs, insbesondere als Einzelschalter oder Schaltmodul im Lenkstockbereich, z.B. bei Lichtschaltern, Wischerschaltern, Fensterheberschaltern oder Schaltmodule für andere Komponenten, z.B. Tempomat u.dgl.. Außerdem sind derartige Schaltmodule auch als Multifunktionsschaltmodule oder in Multifunktionsschaltermodulen einsetzbar. Durch geringen Montageaufwand sowie geringere Anzahl von günstigen Einzelkomponenten ist außerdem eine Kostenersparnis zu erwarten.

Ein weiterer Vorteil des erfindungsgemäßen Schaltmoduls ist, dass die Lebensdauer aufgrund des berührungslos schaltenden Schaltgliedes wesentlich erhöht werden kann. Außerdem können die erfindungsgemäßen Schaltmodule dieselbe Außenkontur wie bereits bekannte, mechanisch geschaltete Schaltmodule aufweisen, wodurch es möglich ist, die erfindungsgemäßen Schaltmodule in denselben Bauraum wie bereits bekannte Schaltmodule unterzubringen.

Eine Weiterbildung des erfindungsgemäßen Schaltmoduls sieht vor, dass die Steuerstrombahn eine Lichtschranke mit einer Sendediode und einem Fotoempfänger aufweist und dass das Schaltglied eine in die Lichtschranke einführbare Blende aufweist. Durch ein Einführen der Blende in eine definierte Schaltstellung, wird ein sicheres und funktionssicheres Schalten der Steuerstrombahn zu einem vorgegebenen Schaltpunkt ermöglicht. Eine solche Weiterbildung der Erfindung eignet sich insbesondere auch zum Schalten von sehr kleinen Strömen.

Bei einer weiterentwickelten Ausführungsform der Erfindung ist vorgesehen, dass der Schaltarm seitlich an der Sendediode und/oder an dem Fotoempfänger vorbeiführbar und die Blende rechtwinklig an dem Schaltarm angeordnet ist. Durch eine solche geometrische Ausgestaltung des Schaltarms mit Blende ist insbesondere eine kompakte Bauweise des Schaltmoduls möglich.

Bei einer Variante der Erfindung ist vorgesehen, dass die Steuerstrombahn einen Magnetfeldsensor, insbesondere ein Hallelement, aufweist und dass das Schaltelement einen in den Detektionsbereich des Magnetfeldsensors führbaren Magneten aufweist. Durch das Schalten des Schaltarms in eine definierte Schaltstellung ist es erfindungsgemäß möglich, den Schaltpunkt exakt zu definieren.

Bei einer Ausgestaltung der Erfindung ist vorgesehen, dass der Schaltarm mittels einer Schwenklagerung um eine Schwenkachse schwenkbar gelagert ist und einen der Betätigungseinheit zugewandten und einen der Betätigungseinheit abgewandten Abschnitt aufweist. Auf diese Weise kann der Schaltarm um die Schwenkachse in definierte und vorgegebene Schaltstellungen betätigt werden.

Bei einer Variante der Erfindung ist vorteilhafterweise die Schwenklagerung an dem Schaltmodulgehäuse gehaltert. Auch damit ist eine kompakte Bauweise des Schaltmoduls möglich.

Eine andere Weiterbildung der Erfindung sieht vor, dass an dem der Betätigungseinheit abgewandten Abschnitt des Schaltarms das Schaltglied angeordnet ist. Vorteilhafterweise kann aufgrund der Länge des der Betätigungseinheit abgewandten Abschnitts der von dem Schaltglied zurückgelegte Schaltweg eingestellt und an das vorgesehene Schaltverhalten des jeweiligen Schaltmoduls angepasst werden.

Eine weitere Ausgestaltung der Erfindung zeichnet sich dadurch aus, dass die Betätigungseinheit auf der dem Schaltarm zugewandten Seite ein keilförmiges Element mit zwei Keilflächen und einer Keilkante aufweist, wobei die Keilkante parallel zu der Schwenkachse verläuft. Diese Ausführungsform weist den Vorteil auf, dass aufgrund des keilförmigen Elements der Schaltarm von der einen Schaltstellung, ohne Verbleiben des Schaltarms in einer Zwischenstellung, in die andere definierte Schaltstellung betätigt werden kann. Bei Betätigung der Betätigungseinheit ist vorgesehen, dass der Schaltarm so lange auf einer der beiden Keilflächen anliegt, bis die Betätigungseinheit über einen kritischen Punkt betätigt wird, in dem der Schaltarm über die Keilkante bewegt wird und in die andere Schaltstellung gelangt. Aufgrund der parallelen Anordnung der Schwenkachse zu der Keilkante kann ein sicheres Verschwenken des Schaltarms von der einen Keilfläche bzw. von der einen Schaltstellung zu der anderen Keilfläche bzw. der anderen Schaltstellung erfolgen.

Bei einer Weiterbildung der Erfindung wird bei Betätigung der Betätigungseinheit das keilförmige Element in dem Schaltmodul parallel verschoben. Insbesondere ein solches paralleles Verschieben des keilförmigen Elements gewährleistet ein sicheres Umschalten des Schaltarms von der einen Schaltstellung in die andere Schaltstellung.

Eine Variante der Erfindung ist dadurch gekennzeichnet, dass das der Betätigungseinheit zugewandte Ende des Schaltarms während des Schaltvorgangs von einer Schaltstellung in die andere erst auf der einen und dann auf der anderen Keilfläche des keilförmigen Elements aufliegt. Durch ein solches Aufliegen des einen Endes des Schaltarms an dem keilförmigen Element wird ein sicheres und schaltpunktgenaues Schalten des Schaltmoduls erreicht.

Bei einer Ausgestaltung der Erfindung ist das keilförmige Element an der Betätigungseinheit axial federnd gehaltert. Aufgrund einer solchen Halterung werden während der Betätigung der Betätigungseinheit die Keilflächen des keilförmigen Elements an das der Betätigungseinheit zugewandte freie Ende des Schaltarms angedrückt. Damit wird die Funktionssicherheit und die Genauigkeit des Schaltpunktes des Schaltmoduls wesentlich verbessert.

Bei einer Weiterbildung des erfindungsgemäßen Schaltmoduls ist vorgesehen, dass die Betätigungseinheit orthogonal zu der Mittelebene des keilförmigen Elements betätigbar ist. Eine solche Betätigbarkeit der Betätigungseinheit bringt den Vorteil mit sich, dass das keilförmige Element aufgrund der Betätigung der Betätigungseinheit derart in dem Schaltmodulgehäuse parallel verschoben wird, dass ein günstiges Bewegen des Schaltarms von der einen Keilfläche zu der anderen Keilfläche des keilförmigen Elements möglich ist.

Eine weitere Ausgestaltung der Erfindung zeichnet sich dadurch aus, dass die Betätigungseinheit entlang der Betätigungseinrichtung federnd gehaltert ist. Damit kann erreicht werden, dass nach Betätigung der Betätigungseinheit diese in ihre Ausgangsposition zurückverfahren wird, was insbesondere bei Schaltmodulen, mittels welchen lediglich ein Schaltimpuls erzeugt wird, der über die Steuerstrombahn beispielsweise einer Auswerteeinheit mit insbesondere einem Mikroprozessor zugeführt wird, von Bedeutung ist.

Bei einer besonders bevorzugten Ausgestaltung der Erfindung ist vorgesehen, dass der Schaltarm aufgrund der federnden Halterung der Betätigungseinheit und/oder des keilförmigen Elements in den Schaltstellungen unter Federbelastung angeordnet ist. Dadurch wird erreicht, dass der Schaltarm nicht aufgrund von beispielsweise seinem Eigengewicht eine definierte Schaltstellung verlässt, was zu Funktionsstörungen des Schaltmoduls führen kann. Außerdem werden durch Vibrationen und Erschütterungen des Fahrzeugs hervorgerufene negative Beeinflussungen der Schalterstellung ausgeschlossen.

Bei einer anderen Weiterbildung der Erfindung wird die Bewegung des Schaltarms durch Begrenzungselemente begrenzt. Dies hat den Vorteil, dass der Schaltarm lediglich in einem vorgegebenen definierten Bereich bewegbar ist.

Ebenso kann erfindungsgemäß vorgesehen sein, dass die Betätigung der Betätigungseinheit durch Begrenzungselemente begrenzt wird. Auch dies führt zu einer funktionssicheren Betätigung des Schaltmoduls.

Bei einer Weiterbildung der Erfindung bildet die Innenseite des Schaltmodulgehäuses die Begrenzungselemente. Vorteilhafterweise kann dadurch das Schaltmodul sehr kompakt ausgestaltet werden.

Weitere vorteilhafte Ausgestaltungen und Einzelheiten der Erfindung sind der folgenden Beschreibung zu entnehmen, in der die Erfindung anhand des in der Zeichnung dargestellten Ausführungsbeispiels näher beschrieben und erläutert ist.

Es zeigen:
- Fig. 1:: ein Schaltmodul mit optisch schaltendem Schaltglied als Öffner in nicht betätigtem Zustand;
- Fig. 2:: ein Schaltmodul nach Fig. 1 in betätigtem Zustand;
- Fig. 3:: ein Schaltmodul mit optischem Schaltelement als Schließer in dem nicht betätigten Zustand;
- Fig. 4:: ein Schaltmodul nach Fig. 3 in betätigtem Zustand;
- Fig. 5:: ein Schaltmodul mit magnetischem Schaltglied in nicht betätigtem Zustand;
- Fig. 6:: eine Ausführungsform des Schaltmoduls nach Fig. 3.

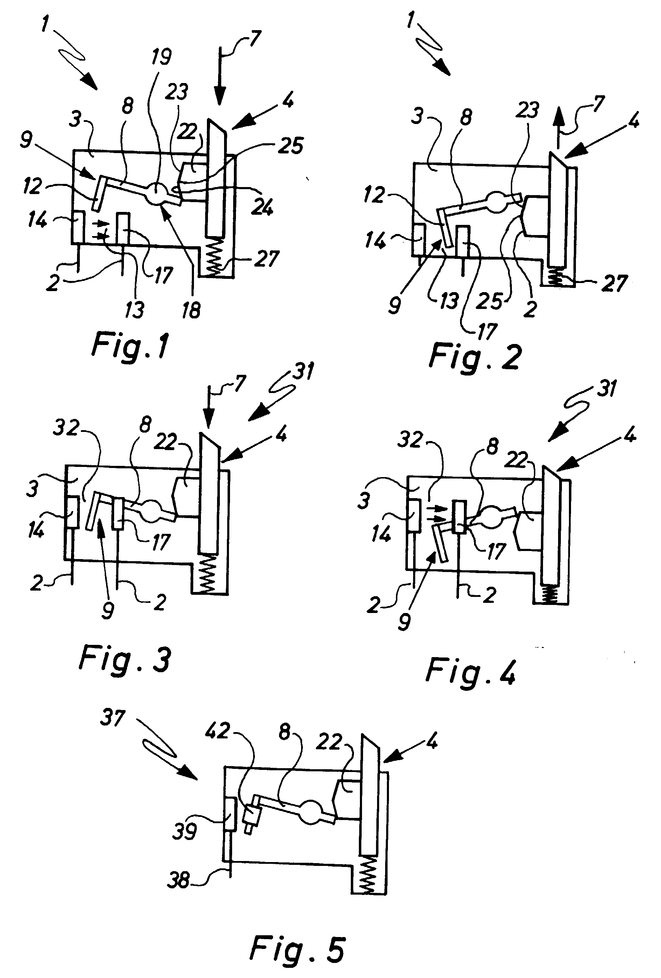

In der Fig. 1 und 2 ist ein Schaltmodul 1 zum Schalten von einer Steuerstrombahn 2 mit einem Schaltgehäuse 3 und mit einer von einer menschlichen Person betätigbaren Betätigungseinheit 4 dargestellt. Die Betätigungseinheit 4 ist dabei als Druckschalter ausgeführt, welcher in Richtung des Pfeils 7 heruntergedrückt bzw. betätigt werden kann. Das Schaltmodul 1 weist außerdem einen innerhalb des Schaltmodulgehäuses 2 angeordneten Schaltarm 8 auf, der von der in Fig. 1 gezeigten Schaltstellung ohne ein Verbleiben des Schaltarms 8 in einer Zwischenstellung in eine andere, in Fig. 2 gezeigte, Schaltstellung betätigbar ist. An dem Schaltarm 8 ist ein Schaltglied 9, nämlich eine Blende 12, angeordnet. Die Blende 12 schaltet dabei die Steuerstrombahn 2 berührungslos, indem sie in eine in der Strombahn 2 angeordnete Lichtschranke 13 einführbar ist. Die Lichtschranke 13 weist eine Sendediode 14 und einen Fotoempfänger 17 auf, zwischen welche die Blende 12 zur Schaltung des Schaltmoduls 1 eingeführt werden kann. Das als Öffner ausgeführte Schaltmodul 1 ist in Fig. 1 in nicht betätigtem Zustand dargestellt, d.h. die Steuerstrombahn 12 ist über die Lichtschranke 13 geschlossen.

Wie aus Fig. 1 und Fig. 2 hervorgeht, ist der Schaltarm 8 mittels einer Schwenklagerung 18 um eine Schwenkachse 19 schwenkbar gelagert. Der Schaltarm 8 weist dabei einen der Betätigungseinheit 4 zugewandten und einen der Betätigungseinheit 4 abgewandten Abschnitt auf. Vorteilhafterweise kann dabei die Schwenklagerung 18 an dem Schaltmodulgehäuse 3 gehaltert sein.

Wie deutlich aus den Fig. 1 und 2 hervorgeht, ist an dem der Betätigungseinheit 4 abgewandten Abschnitt des Schaltarms 8 das Schaltglied 9 angeordnet.

Die Betätigungseinheit 4 weist auf der dem Schaltarm 8 zugewandten Seite ein keilförmiges Element 22 mit zwei Keilflächen 23 und 24 sowie einer Keilkante 25, die parallel zu der Schwenkachse 19 verläuft, auf. Erfindungsgemäß ist ebenfalls denkbar, dass das Betätigungselement 4 mit dem keilförmigen Element 22 einstückig ausgestaltet ist.

Wie in Fig. 1 gezeigt, liegt in der geöffneten Schalterstellung des Schaltmoduls 1 das der Betätigungseinheit 4 zugewandte Ende des Schaltarms 8 an der Keilfläche 24 an. Während des Betätigungsvorgangs des Betätigungselements 4 entlang der Pfeilrichtung 7 verharrt der Schaltarm 8 zunächst in einer in Fig. 1 gezeigten Stellung. Bei weiterer Betätigung, die orthogonal zu der Mittelebene des keilförmigen Elements 22 erfolgt, schnappt das dem Betätigungselement 4 zugewandte Ende des Schaltarms 8 über die Keilkante 25, auf die Keilfläche 23. Aufgrund der Keilkante 25 und den beiden Keilflächen 23 und 24 ist ausgeschlossen, dass der Schaltarm 8 in einer Zwischenstellung zwischen den beiden Schaltstellungen verbleibt.

Aufgrund der entsprechenden Längen der beiden von der Schwenklagerung 18 miteinander verbundenen Abschnitte des Schaltarms 8 kann erreicht werden, dass in der betätigten Stellung des Schaltmoduls 1 nach Fig. 2 das Schaltglied 9 in die Lichtschranke 13 eingreift.

Wie in Fig. 1 und 2 gezeigt ist, ist die Betätigungseinheit 4 mittels einer Feder 27 entlang der durch den Pfeil 7 angedeuteten Betätigungsrichtung federnd gehaltert. Dadurch wird erreicht, dass nach einer Betätigung der Betätigungseinheit 4 die Betätigungseinheit 4 wieder in ihre Ausgangsposition zurückgeführt wird.

Das in Fig. 3 und 4 gezeigte Schaltmodul 31, welches als Schließer ausgeführt ist, weist einen ähnlichen Aufbau wie das Schaltmodul 1 nach Fig. 1 und 2 auf. Der Hauptunterschied zwischen dem Schaltmodul 1 und dem Schaltmodul 31 besteht darin, dass bei dem Schaltmodul 31 eine Lichtschranke 32 innerhalb des Schaltergehäuses 3 so angeordnet ist, dass sie bei nicht betätigtem Betätigungselement 4, wie in Fig. 3 gezeigt, unterbrochen ist. Bei betätigtem Betätigungselement 4 des Schaltmoduls 31 ist eine Verbindung der Strombahn 2 über die Lichtschranke 32 möglich, was Fig. 4 zeigt.

In Fig. 5 ist eine andere Ausführungsform eines erfindungsgemäßen Schaltmoduls dargestellt, nämlich ein Schaltmodul 37, bei welchem die Steuerstrombahn 38 einen Magnetfeldsensor 39, insbesondere ein Hallelement, aufweist. Außerdem weist das Schaltelement 9 einen in den Detektionsbereich des Magnetfeldsensors 39 einführbaren Magneten 42 auf. Der Aufbau des in Fig. 5 gezeigten Schaltmoduls 37 entspricht dem Aufbau der in Fig. 1 bis 4 gezeigten Schaltmodule 1 und 31. Bei Betätigung des Schaltmoduls 37 wird der Magnet 42 aus dem Detektionsbereich des Magnetfeldsensors 39 geführt, wodurch ein Schaltimpuls ausgelöst wird, der über die Steuerstrombahn 38 einer entsprechenden Auswerteeinheit zugeführt und ausgewertet wird.

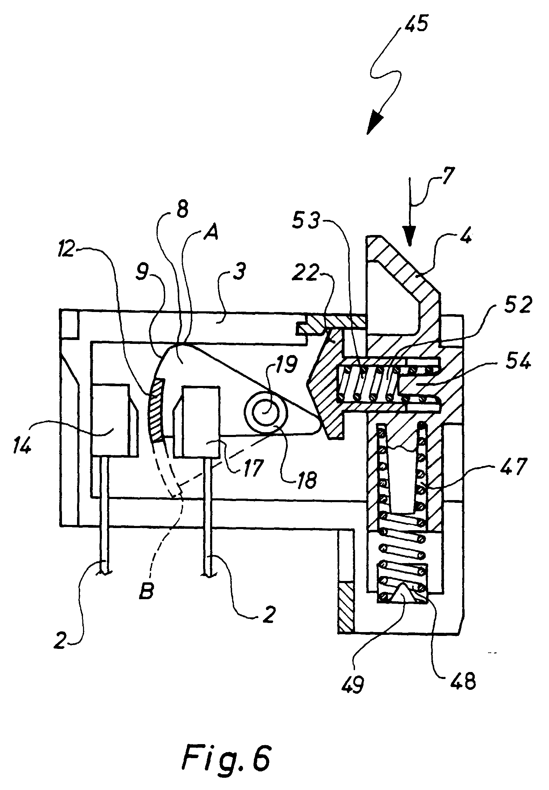

In der Fig. 6, in der ein dem in Fig. 3 und 4 gezeigten Schaltmodul 31 entsprechendes Schaltmodul 45 gezeigt ist, weist die Betätigungseinheit 4 einen Federschaft 47 zur Aufnahme einer Feder 48 auf. Die Feder 48 ist dabei auf ihrer dem Schaltmodulgehäuse 3 zugewandten Seite mittels eines Zentrierzapfens 49 an dem Schaltmodulgehäuse 3 geführt. Beim Betätigen der Betätigungseinheit 4 in Richtung des Pfeils 7 ist die Federkraft der Feder 48 entgegen der Betätigungsrichtung 7 gerichtet. Ein Abknicken der Feder 48 wird aufgrund des Federschafts 47 vermieden.

Wie in Fig. 6 deutlich zu erkennen ist, weist das keilförmige Element 22 auf seiner von der Schwenklagerung 18 abgewandten Seite eine Zylinderbohrung 52 auf, die als Federschacht ausgestaltet ist und zur Aufnahme einer Feder 53 vorgesehen ist. Die Feder 53 wird mittels eines Zentrierzapfens 54 an der Betätigungseinheit 4 geführt. Aufgrund der Feder 53 ist das keilförmige Element 22 an der Betätigungseinheit 4 axial federnd gehaltert. Mittels einer solchen Feder 53 kann gewährleistet werden, dass der Schaltarm 8 in den Schalterstellungen stets unter Federbelastung angeordnet ist. Damit ist ein Verharren des Schaltarms 8 in den Schaltstellungen gewährleistet.

Wie aus Fig. 6 hervorgeht, wird der Schaltarm 8 an dem Fotoempfänger 17 seitlich vorbeigeführt, wobei die Blende 12 rechtwinklig an dem Schaltarm 8 angeordnet ist.

Das in Fig. 6 gezeigte Schaltmodul 45 weist außerdem die Bewegung des Schaltarms 8 sowie die Betätigung der Betätigungseinrichtung 4 begrenzende Begrenzungselemente, nämlich die Innenseite des Schaltmodulgehäuses, auf. Bei der in Fig. 6 gezeigten Schalterstellung liegt der Schaltarm 8 im Punkt A an der Innenseite des Schaltmodulgehäuses 3 an. Damit ist die Schwenkbarkeit der Blende 12 um die Schwenkachse 19 begrenzt.

In Fig. 6 ist die Position der Blende 12 bzw. des Schaltglieds 9 bei betätigtem Betätigungselement 4 gestrichelt gezeigt. In dieser Schaltstellung liegt die untere Seite des Schaltglieds 9 im Punkt B an der Innenseite des Schaltmodulgehäuses an. Damit ist auch in dieser Schalterstellung eine Begrenzung der Schwenkbewegung des Schaltglieds 9 bzw. der Blende 12 gegeben.

Bei Betätigung des Betätigungselements 4 des Schaltmoduls 45 wird das keilförmige Element 22 aufgrund der axialen Verschiebbarkeit des keilförmigen Elements 22 und der dazu orthogonal gerichteten Betätigungsrichtung 7 parallel in dem Schaltmodulgehäuse 3 verschoben. Ein solches paralleles Verschieben des keilförmigen Elements 22 unter entsprechender Federbelastung gewährleistet, dass das dem keilförmigen Element 22 zugewandte Ende des Schaltarms 8 stets an einer der beiden Keilflächen 23 oder 24 anliegt und der Schaltarm 8 stets unter Federbelastung steht.

Alle in der Beschreibung, den nachfolgenden Ansprüchen und der Zeichnung dargestellten Merkmale können sowohl einzeln als auch in beliebiger Kombination miteinander erfindungswesentlich sein.

## Patentansprüche

1. Schaltmodul (1, 31, 37, 45) zum Schalten von Steuerstrombahnen (2), insbesondere in Fahrzeugen, mit einem Schaltmodulgehäuse (3), mit einer insbesondere von einer menschlichen Person betätigbaren Betätigungseinheit (4) und mit einem mit der Betätigungseinheit (4) in Verbindungswirkung stehenden, die Steuerstrombahn (2) schaltenden Schaltglied (9), **dadurch gekennzeichnet**, dass die Betätigungseinheit (4) einen in dem Schaltmodulgehäuse (3) angeordneten Schaltarm (8) von einer definierten Schaltstellung ohne ein Verbleiben des Schaltarms (8) in einer Zwischenstellung in eine andere definierte Schaltstellung betätigt, dass an dem Schaltarm (8) das Schaltglied (9) angeordnet ist und dass das Schaltglied (9) die Steuerstrombahn (2) berührungslos schaltet.

2. Schaltmodul (1, 31, 45) nach Anspruch 1, **dadurch gekennzeichnet**, dass die Steuerstrombahn (2) eine Lichtschranke (13) mit einer Sendediode (14) und einem Fotoempfänger (17) aufweist und dass das Schaltglied (9) eine in die Lichtschranke (13) einführbare Blende (12) aufweist.

3. Schaltmodul 1, 31, 45) nach Anspruch 2, **dadurch** **gekennzeichnet**, dass der Schaltarm (8) seitlich an der Sendediode (14) und/oder an dem Fotoempfänger (17) vorbeiführbar und die Blende (12) rechtwinklig an dem Schaltarm (8) angeordnet ist.

4. Schaltmodul (37) nach Anspruch 1, **dadurch gekennzeichnet**, dass die Steuerstrombahn (38) einen Magnetfeldsensor (39), insbesondere ein Hallelement, aufweist und dass das Schaltelement (9) einen in den Detektionsbereich des Magnetfeldsensors (39) führbaren Magneten (42) aufweist.

5. Schaltmodul (1, 31, 37, 45) nach einem der vorhergehenden Ansprüche, **dadurch gekennzeichnet**, dass der Schaltarm (8) mittels einer Schwenklagerung (18) um eine Schwenkachse (19) schwenkbar gelagert ist und einen der Betätigungseinheit (4) zugewandten und einen der Betätigungseinheit (4) abgewandten Abschnitt aufweist.

6. Schaltmodul (1, 31, 37, 45) nach Anspruch 5, **dadurch gekennzeichnet**, dass die Schwenklagerung (18) an dem Schaltmodulgehäuse (3) gehaltert ist.

7. Schaltmodul (1, 31, 37, 45) nach Anspruch 5 oder 6, **dadurch gekennzeichnet**, dass an dem der Betätigungseinheit (4) abgewandten Abschnitt des Schaltarms (8) das Schaltglied (4) angeordnet ist.

8. Schaltmodul (1, 31, 37, 45) nach Anspruch 5, 6 oder 7, **dadurch gekennzeichnet**, dass die Betätigungseinheit (4) auf der dem Schaltarm (8) zugewandten Seite ein keilförmiges Element (22) mit zwei Keilflächen (23, 24) und einer Keilkante (25) aufweist, wobei die Keilkante (25) parallel zu der Schwenkachse (19) verläuft.

9. Schaltmodul (1, 31 37, 45) nach Anspruch 8, **dadurch gekennzeichnet**, dass bei Betätigung der Betätigungseinheit (4) das keilförmige Element (22) in dem Schaltmodulgehäuse parallel verschoben wird.

10. Schaltmodul (1, 31, 37, 45) nach Anspruch 8 oder 9, **dadurch gekennzeichnet**, dass das der Betätigungseinheit (4) zugewandte Ende des Schaltarms (8) während des Schaltvorgangs von einer Schaltstellung in die andere zuerst auf der einen (24) und dann auf der anderen (23) Keilfläche des keilförmigen Elements (22) anliegt.

11. Schaltmodul (45) nach Anspruch 8, 9 oder 10, **dadurch gekennzeichnet**, dass das keilförmige Element (22) an der Betätigungseinheit (4) axial federnd gehaltert ist.

12. Schaltmodul (1, 31, 37, 45) nach einem der Ansprüche 8 - 11, **dadurch gekennzeichnet**, dass die Betätigungseinheit (4) orthogonal zu der Mittelebene des keilförmigen Elements (22) betätigbar ist.

13. Schaltmodul (1, 31, 37, 45) nach einem der vorhergehenden Ansprüche, **dadurch gekennzeichnet**, dass die Betätigungseinheit (4) entlang der Betätigungsrichtung (7) federnd gehaltert ist.

14. Schaltmodul (1, 31, 37, 45) nach einem der vorhergehenden Ansprüche, **dadurch gekennzeichnet**, dass der Schaltarm (8) aufgrund der federnden Halterung der Betätigungseinheit (4) und/oder des keilförmigen Elements (22) in den Schaltstellungen unter Federbelastung angeordnet ist.

15. Schaltmodul (45) nach einem der vorhergehenden Ansprüche, **dadurch gekennzeichnet**, dass die Bewegung des Schaltarms (8) durch Begrenzungselemente begrenzt wird.

16. Schaltmodul (45) nach einem der vorhergehenden Ansprüche, **dadurch gekennzeichnet**, dass die Betätigung der Betätigungseinheit (4) durch Begrenzungselemente begrenzt wird.

17. Schaltmodul (45) nach Anspruch 15 oder 16, **dadurch gekennzeichnet**, dass die Innenseite des Schaltmodulgehäuses (3) die Begrenzungselemente bildet.
